# FASCICULE DE BREVET EUROPEEN

(11) **EP 0 773 590 B1**
(45) Date de publication et mention de la délivrance du brevet: **12.08.2009**
(21) Numéro de dépôt: 96402349.3
(22) Date de dépôt: 05.11.1996
(51) Int. Cl.: H01L 31/0236, H01L 31/0216, H01L 31/18

(54) **Procédé de texturisation de la surface du silicium multicristallin de type p et cellule solaire comportant du silicium multicristallin de type p**
Verfahren zum Texturieren der Oberfläche von multikristallinem Silizium vom p-Typ und multikristallines Silizium vom p-Typ enthaltende Solarzelle
Method of texturing the surface of p-type multicrystalline silicon and solar cell comprising multicrystalline silicon of p-type

(30) Priorité: 13.11.1995 FR 9513415
(43) Date de publication de la demande: 14.05.1997
(73) Titulaire: Photowatt International S.A., 38300 Bourgoin-Jallieu (FR)
(72) Inventeur: Le, Quang Nam, 38300 Bourgoin-Jallieu (FR); Sarti, Dominique, 38300 Bourgoin-Jallieu (FR); Levy-Clement, Claude, 92195 Meudon (FR); Bastide, Stéphane, c/o Photowatt International SA, 38300 Bourgoin-Jallieu (FR)
(74) Mandataire: Prugneau, Philippe

(56) Documents cités:
- DE-A- 3 324 232
- SOLAR ENERGY MATERIALS AND SOLAR CELLS, vol. 37, no. 1, Avril 1995, AMSTERDAM NL, pages 13-24, XP000517030 P. MENNA ET AL.: "Porous silicon in solar cells: a review and a description of its application as an AR coating"
- 13TH EUROPEAN PHOTOVOLTAIC SOLAR ENERGY CONFERENCE, 23 - 27 Octobre 1995, NICE, FR, pages 37-40, XP002008173 E. VAZSONYI ET AL.: "High efficiency silicon pv cells with surface treatment by anodic etching"
- PATENT ABSTRACTS OF JAPAN vol. 15, no. 258 (E-1084) 28 Juin 1991 & JP-A-03 083 339 (SUMITOMO ELECTRIC IND. LTD.) 09 Avril 1991
- 23RD IEEE PHOTOVOLTAIC SPECIALISTS CONFERENCE, 10 - 14 Mai 1993, LOUISVILLE, USA, pages 287-293, XP002008174 Y.S. TSUO ET AL.: "Potential application of porous silicon in photovoltaics"
- 12TH EUROPEAN PHOTOVOLTAIC SOLAR ENERGY CONFERENCE, 11 - 15 Avril 1994, AMSTERDAM, NL, pages 780-783, XP002008175 S. BASTIDE ET AL.: "The effect of porous silicon on the emitter of a photovoltaic cell"

## Description

Le silicium cristallin a de nombreuses applications dans les domaines suivants: photoélectricité, photovoltaïque, optique, thermique, micro-électronique, et dans l'industrie des semi-conducteurs. La présente invention concerne une cellule solaire ou photopile dont la surface recevant le rayonnement lumineux est constituée de silicium multicristallin. Elle porte plus particulièrement sur une cellule solaire comportant du silicium dont la surface a été modifiée par un traitement de texturisation afin d'en accroître les performances optiques.

La texturisation consiste à créer une rugosité à la surface du matériau afin de permettre une multiréflexion de la lumière incidente sur sa surface, conduisant à une absorption plus importante de la lumière à l'intérieur du matériau. La rugosité ainsi obtenue a deux effets complémentaires. Le premier effet est une réduction du pouvoir réfléchissant ou réflectivité optique de la surface; le deuxième est un accroissement du chemin optique parcouru par la lumière incidente à l'intérieur du matériau. Dans le cas d'une photopile, l'augmentation de l'absorption de la lumière dans le silicium se traduit par une augmentation de l'efficacité de la transformation de la lumière en courant électrique.

Plusieurs méthodes permettent d'atteindre ce résultat et conduisent à une texturisation uniforme de la surface en révélant des plans cristallographiques bien définis. On peut citer des méthodes comme la gravure mécanique, la gravure laser, la photolithographie, le masquage, etc., mais leur mise en oeuvre est complexe et coûteuse. La méthode de texturisation de surface actuellement connue et employée à l'échelle industrielle consiste à utiliser à température élevée une solution aqueuse alcaline à base d'hydroxyde de sodium (NaOH) ou de potassium (KOH). Ces solutions ont la propriété d'attaquer le silicium de façon anisotrope selon l'orientation cristallographique des grains situés en surface, et ainsi de modifier la morphologie de surface du silicium. La vitesse d'attaque est environ cent fois plus rapide sur les plans d'orientation cristallographique [100] que sur les plans [111]. Il en résulte une texturisation de la surface sous forme de pyramides régulières situées sur les plans [100] qui piègent la lumière incidente, et que l'on désigne sous le terme de "macrotexturisation". En ce qui concerne le silicium multicristallin, on estime que 20% seulement de la surface est constituée par des grains ayant cette orientation cristallographique, ce qui entraîne une efficacité moindre du traitement vis à vis de la réflectivité optique. Cette méthode n'est donc entièrement efficace que dans le cas particulier du silicium monocristallin avec une orientation cristallographique [100] qui est celle de la surface à traiter.

Pour réduire de manière plus importante la réflectivité optique d'une surface de silicium monocristallin de type n, des travaux portant sur une attaque photoélectrochimique en milieu acide ont été effectués par A.LAGOUBI et al. (11th Photovoltaic Solar Energy Conference, Montreux, 1992 Pages 250-253). La superposition d'une couche externe nanoporeuse (pores de diamètre inférieur à 50 nm) et d'une couche interne macroporeuse (pores de diamètre supérieur à 50 nm) est révélée par la dissolution de la couche nanoporeuse. La surface revêtue de la couche macroporeuse présente une réflectivité réduite par rapport à la surface non traitée.

Ces travaux présentent l'inconvénient de concerner uniquement un silicium monocristallin de type n. De plus une méthode photoélectrochimique n'est pas d'utilisation aisée en milieu industriel.

Les utilisateurs ont donc besoin de disposer d'une méthode applicable industriellement pour réaliser la texturisation homogène de la surface du silicium multicristallin quelle que soit l'orientation cristallographique des grains à sa surface. Ainsi, des travaux présentés dans "Solar energy materials and cells" (vol. 37, n°1, avril 1995, Amsterdam NL, pages 13-24) et dans "23rd IEEE Photovoltaic specialists conference (10-14 mai 1993, Louisville, USA, pages 287 - 293) décrivent la formation d'une couche anti-reflet à la surface du silicium multicristallin de type p par attaque chimique de la surface au moyen d'une solution de HF/HNO3. La surfaçe de silicium présente alors une structure nanoporeuse qui diminue la réflectivité de la cellule et augmente ainsi son efficacité. L'anti - réflectivité ainsi que les caractéristiques d'absorption de la surface par cette texturisation chimique ne sont pas encore optimales.

L'invention a pour but de proposer une cellule solaire comportant du silicium multicristallin dont l'efficacité est améliorée par rapport aux cellules solaires connues et utilisées aujourd'hui.

Un autre but de la présente invention est de proposer un procédé de texturisation de la surface du silicium multicristallin de type p qui soit efficace et économique et qui permette d'en abaisser la réflectivité optique de manière significative et d'augmenter son absorption effective.

La présente invention a pour objet un procédé de texturisation d'une surface de silicium multicristallin de type p et de ses alliages, comprenant une étape d'oxydation chimique partielle isotropique de ladite surface par une solution oxydante contenant en outre des ions fluor, dans le but de créer à ladite surface de silicium une couche poreuse superficielle **caractérisé en ce que** ladite étape d'oxydation est réalisée de sorte que ladite couche poreuse superficielle définit avec le coeur du matériau une interface ayant une surface micro-texturisée comprenant une multitude de trous de forme alvéolaire de profondeur et de diamètre compris entre 0,1µm et 10µm et dont le rapport de ladite profondeur audit diamètre est supérieur à 1 et en ce qu'il comprend en outre une deuxième étape qui consiste à dissoudre ladite couche poreuse superficielle jusqu'à révéler ladite surface micro-texturisée.

Un autre objet de la présente invention est une cellule solaire comprenant du silicium multicristallin, de type p ou l'un de ses alliages, qui présente une surface destinée à recevoir le rayonnement lumineux cette surface étant texturisée par le procédé de l'invention, ladite surface de silicium comportant une multitude de trous de forme alvéolaire, de profondeur comprise entre 0,1µm et 10µm, de diamètre compris entre 0,1µm et 10µm, et dont le rapport de ladite profondeur audit diamètre est supérieur à 1, la surface desdits trous occupant plus de la moitié de ladite surface de silicium.

Les cellules solaires selon l'invention sont réalisées à partir d'un silicium multicristallin, appelé aussi polycristallin, à conduction de type p, ou de l'un de ses alliages notamment avec le germanium. Le silicium peut se présenter sous forme massive, par exemple en plaques minces de quelques centaines de microns d'épaisseur, ou bien sous la forme d'un ruban ou d'une couche mince d'épaisseur de l'ordre de 50µm.

Le silicium des cellules selon l'invention présente une surface criblée de cavités de forme régulière, désignées par l'expression "trous alvéolaires", réparties de manière homogène et dont la situation est indépendante de l'orientation cristallographique des grains de surface. Le rapport entre la profondeur du trou et son diamètre est l'un des paramètres principaux déterminant l'efficacité du piégeage de la lumière incidente à l'intérieur du matériau. Pour l'absorption de la lumière, l'efficacité est d'autant meilleure que la profondeur du trou est la plus grande possible mais inférieure à 15µm, et que le rapport profondeur/diamètre est le plus élevé possible et supérieur à 1.

Selon un autre mode de réalisation de l'invention ladite surface de silicum est recouverte d'une couche antireflet.

La surface à traiter est notamment mais non exclusivement obtenue par sciage. Une surface brut de sciage est propre et exempte d'impuretés risquant d'inhiber l'oxydation chimique. Elle ne nécessite pas de décapage chimique pour obtenir une surface présentant un poli chimique. Dans d'autres cas, un polissage chimique à l'aide d'une solution commerciale est envisageable.

Le silicium poreux est obtenu au cours de la première étape par une oxydation par voie chimique en des endroits localisés de la surface du silicium multicristallin de type p. Cette opération consiste à oxyder une partie du silicium en formant un complexe fluoré qui se dissout, laissant une couche superficielle contenant des vides appelés pores. L'oxydation isotropique du silicium s'obtient exclusivement en présence d'ions fluor. La vitesse de corrosion est partiellement contrôlée par la concentration en ion fluor dans le domaine de concentration compris entre 0,01M et 25M. Dans ces conditions, la corrosion du silicium n'est pas homogène mais localisée ce qui se traduit par la formation de silicium poreux.

Selon une première forme d'exécution de l'invention, ladite solution oxydante est une solution aqueuse acide contenant en outre des ions fluor. De préférence le pH de la solution est inférieur à 5.

Selon une deuxième forme d'exécution de l'invention, ladite solution oxydante est une solution organique contenant en outre des ions fluor, par exemple le milieu organique peut être constitué par de l'acétonitrile CN-CH₃.

De préférence, l'oxydation est réalisée par une solution contenant un agent oxydant choisi parmi l'ion chromate CrO₃⁻ provenant par exemple de l'acide chromique HCrO₃, l'ion bromate BrO₃⁻ fourni par exemple par le bromate de potassium KBrO₃, l'ion nitrate NO₃⁻ provenant par exemple de l'acide nitrique HNO₃, l'ion nitrite NO₂⁻ fourni par exemple par le nitrite de sodium NaNO₂, l'ion amine provenant par exemple de l'éthylène-diamine, un couple rédox métallique comme par exemple les couples Cu²⁺ / Cu⁺, Fe²⁺ / Fe³⁺, I₃⁻ / I⁻, Mn⁷⁺ / Mn²⁺ ou S⁷⁺ / S⁶⁺, et leurs mélanges. Afin d'éviter une perturbation excessive de la surface, il est préférable d'utiliser des faibles concentrations en oxydant.

Pour un meilleur contrôle de la réaction, on peut ajouter dans la solution oxydante un agent inhibiteur afin de ralentir la vitesse de corrosion du silicium, comme par exemple l'acide acétique CH₃COOH ou tout autre composé compatible avec les conditions de la réaction et possédant une constante diélectrique du même ordre de grandeur que l'acide acétique.

A l'issue de la deuxième étape, la dissolution contrôlée du silicium poreux révèle une surface criblée de trous de forme alvéolaire. Cet aspect sera désigné par la suite par le terme "microtexturisation".

Ladite deuxième étape consiste en une dissolution du silicium poreux dans une solution choisie parmi une solution aqueuse alcaline, une solution organique d'éthylène-glycol et une solution organique d'hydrazine. Dans le cas d'une solution aqueuse alcaline, ledit alcalin est de préférence choisi parmi l'hydroxyde de sodium NaOH, l'hydroxyde de potassium KOH, l'ammoniaque NH₄OH et leurs mélanges.

Cette étape de dissolution a pour but d'éliminer la couche poreuse superficielle afin de faire apparaître l'interface entre cette couche et le coeur du matériau. Il s'agit donc de dissoudre de manière contrôlée la couche poreuse formée lors de la première étape. La vitesse de dissolution est liée à la concentration de la solution dissolvante qu'il est avantageux de choisir faible. En effet il est important de maîtriser le déroulement de la réaction afin de ne pas perturber la morphologie de la nouvelle surface révélée par la dissolution du silicium poreux.

Selon une forme d'exécution préférentielle, ladite deuxième étape est réalisée dans une solution aqueuse alcaline dont la concentration en alcalin est comprise entre 0,001M et 2M à une température comprise entre 0°C et 30°C. Un contact rapide compris entre 1 seconde et 5 minutes est généralement suffisant.

La dissolution peut être prolongée jusqu'à ce que la surface ne présente presque plus de microtexturisation. Des mesures de réflexion montrent que la surface est de moins en moins réfléchissante à mesure que le temps de dissolution augmente, pour atteindre une valeur minimale de réflectivité correspondant à une surface microtexturisée selon l'invention. Puis la réflectivité augmente à nouveau lorsque la surface devient plus lisse.

Selon une variante, ledit procédé comprend en outre, avant ladite première étape, une étape préalable d'attaque chimique limitée de ladite surface par une solution aqueuse alcaline à une température supérieure à 30°C. Cette étape consiste à dissoudre une partie du silicium de la surface. Ce traitement analogue au procédé connu de l'art antérieur conduit à une macrotexturisation de la surface du silicium sous forme de structures définies par les plans cristallographiques [111], qui sont des pyramides dans le cas d'une surface orientée [100]. On procède ensuite à la réalisation de la première puis de la deuxième étape du procédé selon l'invention. La dissolution de la couche poreuse de silicium fait apparaître une microtexturisation qui s'ajoute à la macrotexturisation obtenue lors de l'étape préalable pour en augmenter l'efficacité.

Selon une autre variante, ledit procédé comprend en outre, après ladite deuxième étape, une troisième étape consistant dans le dépôt d'une couche antireflet sur ladite surface texturisée. Les performances obtenues avec des surfaces texturisées, selon le procédé de l'invention permettent dans certains cas d'éviter l'emploi de couche antireflet, réduisant d'autant le coût de fabrication.

Le procédé de l'invention a pour avantage d'augmenter la diffusion du rayonnement lumineux dans le silicium à partir de la surface microtexturisée. Le confinement optique est amélioré ce qui autorise l'emploi d'un matériau de moindre qualité électronique et plus économique. La topologie régulière de la surface texturisée permet la réalisation de dépôts fins, par exemple par sérigraphie, en particulier pour la collection du courant électrique. Ainsi la cellule solaire selon la présente invention présente un rendement de conversion photovoltaïque amélioré pour un coût réduit.

L'invention sera mieux comprise et d'autres avantages et particularités apparaîtront à la lecture des exemples suivants de modes de réalisation, donnés à titre illustratif et nullement limitatif, accompagnés du dessin annexé sur lequel:
- la figure 1 est une photographie réalisée par microscopie électronique à balayage (0,5cm = 1µm), qui représente la surface du silicium partiellement microtexturisée par le procédé selon la présente invention,
- la figure 2, analogue à la figure 1, représente la surface du silicium macrotexturisée par la méthode de l'art antérieur,
- la figure 3, analogue à la figure 1, représente la surface du silicium texturisée par le procédé selon l'invention comprenant l'étape préalable d'attaque chimique,
- la figure 4 montre le taux de réflexion du rayonnement lumineux incident sur la surface du silicium en fonction de sa longueur d'onde, selon que cette surface a été texturisée par la méthode de l'art antérieur ou par le procédé selon la présente invention, le taux de réflexion R en dizaines de % (soit x10%) est donné en ordonnée et en abscisse la longueur d'onde incidente L en nm,
- la figure 5 est une coupe schématique d'une cellule solaire selon l'invention,
- la figure 6 donne la variation du courant en fonction de la tension de la cellule solaire selon que celle-ci comporte du silicium dont la surface a été texturisée par la méthode de l'art antérieur ou par le procédé selon la présente invention, l'intensité I en mA figure en ordonnée alors que la tension V en mV est donnée en abscisse,
- la figure 7 montre l'histogramme de répartition des rendements de conversion photovoltaïque obtenus au cours de la fabrication industrielle d'un lot de cellules solaires selon la présente invention, le nombre N de cellules est en ordonnée et le rendement de conversion R est donné sous la forme de classes (référencées de a à 1) en abscisse,
- la figure 8 est analogue à la figure 7 pour un lot de cellules solaires fabriquées selon le procédé de l'art antérieur.

### EXEMPLE 1

On réalise la texturisation de la surface d'un échantillon A de silicium multicristallin de type p selon le procédé de l'invention. La surface de l'échantillon A est partiellement mise au contact avec une solution aqueuse contenant de l'acide nitrique HNO₃ et de l'acide fluorhydrique HF dans un rapport 3. La durée du traitement est d'environ 5 minutes à température ambiante. Le silicium de la surface traitée est ainsi rendu poreux. Cette couche poreuse est ensuite dissoute par un contact rapide avec une solution alcaline d'hydroxyde de sodium NaOH à une concentration d'environ 0,12 M.

On obtient alors une surface microtexturisée présentant des trous alvéolaires dont le diamètre et la profondeur sont de l'ordre de 10 µm.

### EXEMPLE 2

On réalise la texturisation de la surface d'un échantillon B de silicium multicristallin de type p selon le procédé de l'invention. La surface est mise au contact d'une solution aqueuse contenant de l'acide fluorhydrique HF et du nitrite de sodium NaNO₂ dans un rapport de 400. La couche de silicium poreux qui se forme est homogène sur toute la surface et son épaisseur est de l'ordre de 0,6µm. Cette couche poreuse est ensuite dissoute comme décrit dans l'exemple 1.

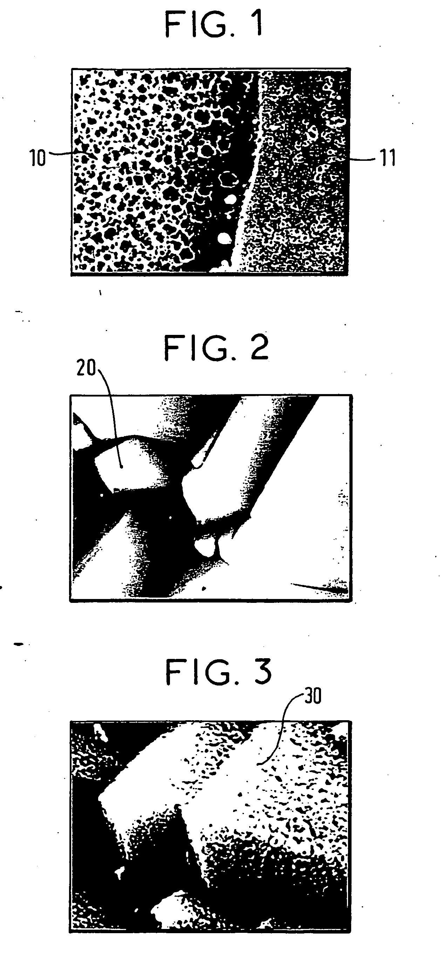

La figure 1 montre la zone 10 de la surface de l'échantillon A de silicium qui a été traitée. La surface microtexturisée est constituée de trous alvéolaires dont la taille est comprise entre 0,1µm et 0,3µm, très supérieure à celle des pores du silicium poreux formé lors de la première étape. La zone 11 contiguë n'a pas subi de traitement.

### EXEMPLE 3

On réalise la texturisation de la surface de deux échantillons C et D de silicium multicristallin de type p.

La surface des échantillons est mise en contact avec une solution alcaline d'hydroxyde de sodium NaOH, de concentration 0,5 M, à la température de 80°C. La figure 2 montre les pyramides 20 qui sont apparues à la surface des échantillons à l'issue du traitement de macrotexturisation selon le procédé connu

Puis la surface de l'échantillon D est mise en contact avec une solution aqueuse contenant de l'acide fluorhydrique HF et du nitrite de sodium NaNO₂ comme décrit dans l'exemple 2. La couche poreuse est ensuite dissoute par une solution alcaline comme décrit dans l'exemple 1.

La figure 3 montre la surface de l'échantillon D après le traitement de microtexturisation selon l'invention. On y voit que la forme des pyramides 30 est légèrement modifiée, les arêtes sont moins nettes, notamment à la base des pyramides, et leur surface présente un aspect cotonneux. La microtexturisation est présente sur toute la surface et le diamètre des trous de forme alvéolaire est de l'ordre de 0,1µm à 0,2µm. Cette microtexturisation est analogue à celle observée sur l'échantillon B de l'exemple 2.

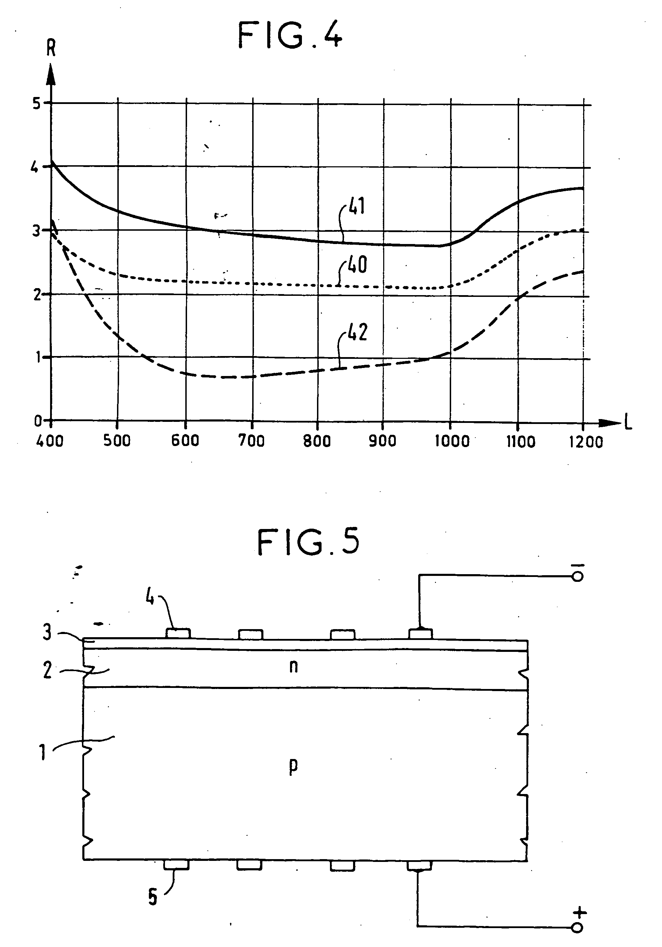

Des mesures de réflexion totale ont été effectuées sur les échantillons C et D précédemment préparés. Les résultats obtenus sont représentés sur la figure 4. Ils montrent que la texturisation effectuée sur l'échantillon D selon le procédé de la présente invention (courbe 40) conduit à une meilleure absorption de la lumière dans le domaine du visible que la seule macrotexturisation réalisée sur l'échantillon C par le procédé de l'art antérieur (courbe 41).

### EXEMPLE 4

On prépare les échantillons E et F respectivement analogues aux échantillons C et D de l'exemple 3, à l'exception du fait qu'ils sont ensuite revêtus d'une couche antireflet.

Des mesures de réflexion totale ont été effectuées sur l'échantillon F de la même manière que dans l'exemple 3. Sur la figure 4, on voit que le dépôt d'une couche antireflet sur l'échantillon F dont la texturisation a été effectuée selon le procédé de la présente invention conduit à une meilleure absorption de la lumière dans le domaine du visible (courbe 42) que la seule microtexturisation réalisée sur l'échantillon D par le procédé de l'invention (courbe 40).

### EXEMPLE 5

On réalise des cellules solaires à partir des échantillons G, H et J préparés de la manière suivante. Les échantillons se présentent sous la forme de plaquettes minces de silicium multicristallin de type p possédant deux faces de grande surface. Chaque face est texturisée. L'échantillon G est traité par le procédé de l'art antérieur dans des conditions analogues à celles utilisées pour l'échantillon C de l'exemple 3. Les échantillons H et J ont été préparés par le procédé selon l'invention de manière analogue à l'échantillon D de l'exemple 3. Par dopage selon un procédé connu, on réalise une jonction n-p sur une face des plaquettes. Puis l'échantillon J est revêtu sur cette face d'une couche antireflet. On adapte ensuite aux échantillons des moyens classiques pour la collection du courant électrique produit sous l'effet du rayonnement lumineux.

Une cellule solaire selon l'invention, comportant du silicium multicristallin de type p préparé de manière analogue à l'échantillon J, est représentée en coupe schématique sur la figure 5. Elle se présente sous la forme d'une plaquette carrée de 10cm de côté et de 200µm d'épaisseur. Après texturisation de l'une des faces de la plaquette de silicium multicristallin de type p, on réalise à sa surface une diffusion d'impuretés (atomes de phosphore, d'arsenic, etc.) qui permettent de doper le silicium multicristallin de type p en type n sans modifier l'aspect de la surface. La plaquette se compose alors d'un coeur 1 de silicium multicristallin de type p dont une face texturisée est recouverte superficiellement d'une couche 2 de faible épaisseur de silicium multicristallin de type n. L'épaisseur de cette couche 2 est de l'ordre de 0,1 à 1µm. On réalise ainsi une jonction n-p. Cette surface, destinée à recevoir le rayonnement lumineux, est revêtue d'une couche antireflet 3, par exemple de TiO₂. Par sérigraphie, on dépose une grille 4 collectrice de courant à base de poudre d'argent constituant le pôle négatif de la cellule. De même la face opposée est revêtue d'une grille collectrice 5 constituant le pôle positif de la cellule.

Les performances des cellules solaires sont évaluées par les méthodes suivantes et les résultats obtenus sont rassemblés dans le tableau I ci-dessous.

La caractéristique courant-tension de la cellule est déterminée en imposant une variation de tension de 0mV à 600mV sous une énergie incidente 1KW/m² selon la norme C.E.I.904-3 (ou I.E.C. 904-3) qui donne une référence de la distribution spectrale d'éclairement solaire.

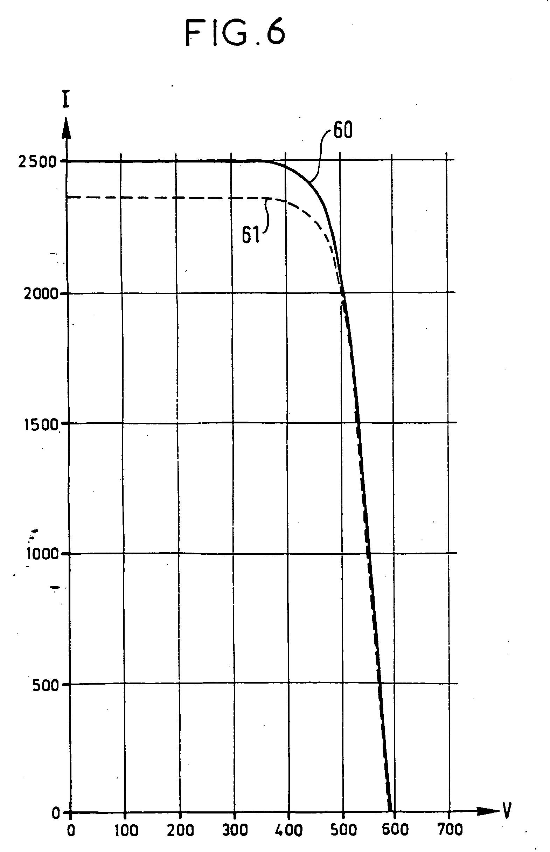

Cette caractéristique est représentée sur la figure 6 par la courbe 60 pour l'échantillon H selon l'invention et par la courbe 61 pour l'échantillon G selon l'art antérieur. On en déduit ainsi les valeurs maximales en courant Imax et en tension Vmax que peut fournir la cellule.

La mesure du courant de court-circuit I_{cc} est effectuée à température ambiante (25°C) pour une tension nulle V=0.

Le rendement de conversion photovoltaïque R est calculé comme le rapport entre l'énergie électrique restituée et l'énergie lumineuse incidente.

**TABLEAU I**

| échantillon | I_{cc} | Vₘₐₓ | Imax | R |
|---|---|---|---|---|
| | (mA) | (mV) | (mA) | % |
| G | 2384 | 488 | 2158 | 10,50 |
| H | 2512 | 492 | 2283 | 11,17 |
| J | 3085 | 496 | 2846 | 14,06 |

Les performances des cellules solaires selon l'invention se traduisent par une augmentation du rendement de conversion photovoltaïque R de 6,4% par rapport à l'art antérieur. Un gain supplémentaire de 26% est obtenu avec ces cellules par l'ajout d'une couche antireflet. De même le courant de court-circuit I_{cc} des cellules de l'invention est supérieur de 5,4% par rapport aux cellules de l'art antérieur.

### EXEMPLE 6

Deux lots comportant chacun environ 400 cellules solaires sont fabriqués industriellement, respectivement avec les échantillons J et K. La préparation de l'échantillon J est décrite dans l'exemple 5. L'échantillon K est préparé de manière analogue à l'échantillon G de l'exemple 5, à l'exception du fait qu'il est revêtu d'une couche antireflet de la même manière que l'échantillon J.

Les cellules réalisées sont évaluées par un test électrique. Le test consiste à imposer à chaque cellule une tension de 450mV et à mesurer le courant qu'elle fournit. Selon le rendement de conversion photovoltaïque R obtenu, les cellules sont rangées par classes, référencées de a à l, où a est la classe correspondant au rendement le plus élevé (R supérieur ou égal à 14%) et où la classe l correspond aux cellules de plus faible rendement (R compris entre 11,50 et 11,25%).

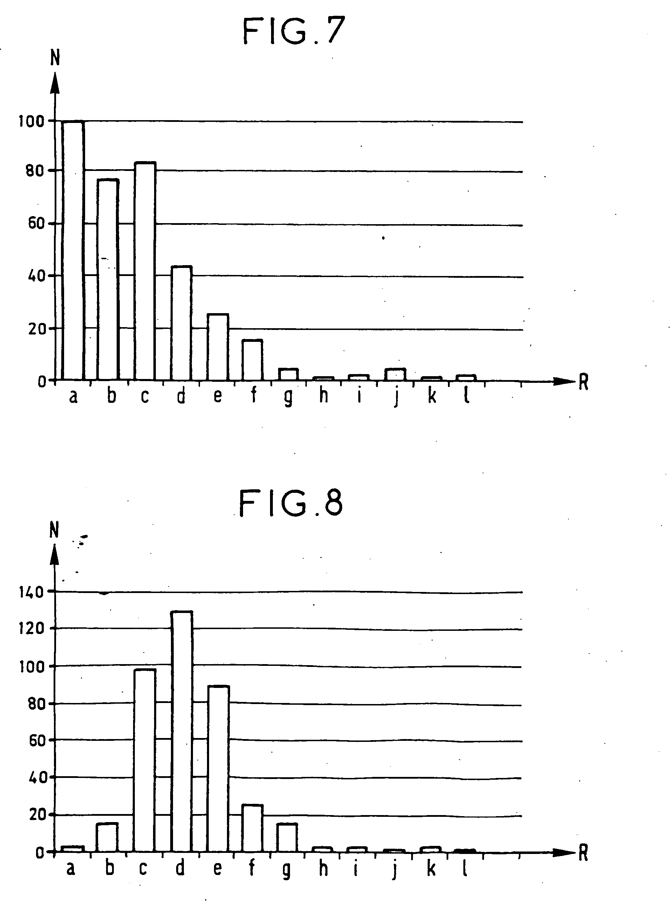

Les histogrammes de répartition sont représentés sur les figures 7 et 8 correspondant respectivement aux échantillons J et K.

Dans le lot fabriqué avec les échantillons K de l'art antérieur, centré sur la classe d (R compris entre 13,50 et 13,25%), les cellules se retrouvent en majorité dans les classes de rendement c à e (R compris entre 13,75 et 13%). Il faut noter que l'on trouve très peu de cellules dans les classes a et b correspondant aux rendement les plus élevés (R supérieur ou égal à 13,75%).

Le lot utilisant les échantillons J selon la présente invention comporte une majorité de cellules qui présentent des rendements situés dans les classes a à c (R supérieur ou égal à 13,50%) correspondant aux rendement les plus élevés.

Bien entendu, les diverses applications numériques fournies ne le sont qu'à titre d'exemple, et la présente invention n'est pas limitée aux modes de réalisation décrits mais elle est susceptible de nombreuses variantes accessibles à l'homme de l'art En particulier les conditions paramétriques des différentes étapes du procédé, comme par exemple la durée ou la température, peuvent être adaptées sans sortir du cadre de la présente invention.

## Revendications

1. Procédé de texturisation d'une surface de silicium multlcristallin de type p et de ses alliages, comprenant une étape d'oxydation chimique partielle isotropique de ladite surface par une solution oxydante contenant en outre des ions fluor, dans le but de créer à ladite surface de silicium une couche poreuse superificielle **caractérisé en ce que** ladite étape d'oxydation est réalisée de sorte que ladite couche poreuse superficielle définit avec le coeur du matériau une interface ayant une surface micro-texturisée comprenant une multitude de trous de forme alvéolaire de profondeur et de diamètre compris entre 0,1µm et 10µm et dont le rapport de ladite profondeur audit diamètre est supérieur à 1 et **en ce qu'**il comprend en outre une deuxiéme étape qui consiste à dissoudre ladite couche poreuse superficielle jusqu'à révéler ladite surface micro-texturisée.

2. Procédé selon la revendication 1, dans lequel ladite solution est une solution aqueuse acide.

3. Procédé selon la revendication 1, dans lequel ladite solution est une solution organique.

4. Procédé selon l'une des revendications 1 à 3, dans lequel ladite solution contient un agent oxydant choisi parmi l'ion chromate, l'ion bromate, l'ion nitrate, l'ion nitrite, l'ion aminé, un couple rédox métallique et leurs mélanges.

5. Procédé selon l'une des revendications 1 à 4, dans lequel ladite solution contient en outre un agent inhibiteur.

6. Procédé selon l'une des revendications 1 à 5, dans lequel ladite deuxième étape consiste en une dissolution dans une solution choisie parmi une solution aqueuse alcaline, une solution organique d'éthylène glycol et une solution organique d'hydrazine.

7. Procédé selon la revendication 6, dans lequel ladite dissolution est effectuée dans une solution aqueuse alcaline dont la concentration en alcalin est comprise entre 0,001M et 2M.

8. Procédé selon l'une des revendications 6 et 7, dans lequel ledit alcalin est choisi parmi l'hydroxyde de sodium, l'hydroxyde de potassium, l'ammoniaque et leurs mélanges.

9. Procédé selon l'une des revendications 1 à 8, comprenant en outre, avant ladite étape d'oxidation chimique une étape préalable d'attaque chimique limitée de ladite surface par une solution aqueuse alcaline à une température supérieure à 30°C.

10. Procédé selon l'une des revendications 1 à 9, comprenant en outre, après ladite deuxième étape, une troisième étape consistant dans le dépôt d'une couche antireflet sur ladite surface.

11. Cellule solaire comprenant du silicium multicristallin de type p, ou l'un de ses alliages, qui présente une surface destinée à recevoir le rayonnement lumineux, cette surface étant texturisée par le procédé selon l'une des revendications 1 à 9, ladite surface comportant une multitude de trous de formes alvéolaires, de profondeur comprise entre 0,1µm et 10µm, de diamètre compris entre 0,1µm et 10µm, et dont le rapport de ladite profondeur audit diamètre est supérieure à 1, la surface des dits trous occupant plus de la moitié de ladite surface de silicium.

12. Cellule solaire selon la revendication 11, dans laquelle ladite surface de silicium est recouverte d'une couche antireflet.

## Claims

1. Method for texturizing a p-type multi-crystalline silicon surface and its alloys, which method comprises a step of isotropic partial chemical oxidation of said surface by an oxidising solution further containing fluorine ions, with the aim of creating on said silicon surface a superficial porous layer, **characterised in that** said step of oxidation is realised such that said superficial porous layer defines with the core of the material an interface having a micro-texturized surface comprising a plurality of alveolar shaped holes of depth and diameter comprised between 0,1 µm and 10 µm and whose depth to diameter ratio is greater than 1, and **in that** is further comprises a second step which consists in dissolving said superficial porous layer until said micro-texturized surface is revealed.

2. Method according to claim 1, wherein said solution is an acid aqueous solution.

3. Method according to claim 1, wherein said solution is an organic solution.

4. Method according to one of claims 1 to 3, wherein said solution contains an oxidising agent selected from chromate ion, bromate ion, nitrate ion, nitrite ion, amine ion, a metallic redox couple and their mixtures.

5. Method according to one of claims 1 to 4, wherein said solution further contains an inhibitor agent.

6. Method according to one of claims 1 to 5, wherein said second step consists in a dissolution in a solution selected from an alkaline aqueous solution, an organic solution of ethylene glycol and an organic solution of hydrazine.

7. Method according to claim 6, wherein said dissolution is realised in an alkaline aqueous solution whose concentration in alkaline is comprised between 0,001 M and 2M.

8. Method according to one of claims 6 and 7, wherein said alkaline is selected from sodium hydroxide, potassium hydroxide, ammonia and their mixtures.

9. Method according to one of claims 1 to 8, further comprising, before said step of chemical oxidation, a previous step of limited chemical etching of said surface by an alkaline aqueous solution at a temperature greater than 30°C.

10. Method according to one of claims 1 to 9, further comprising, after said second step, a third step consisting in a deposition of an antireflection coating on said surface.

11. Solar cell comprising p-type multi-crystalline silicon, or one of its alloys, which presents a surface intended to receive light radiation, said surface being texturized by the method according one of claims 1 to 9, said surface comprising a plurality of alveolar shaped holes, of depth comprised between 0,1 µm and 10 µm, of diameter comprised between 0,1 µm and 10 µm and whose said depth to said diameter ratio is greater than 1, wherein the surface of said holes is occupying more than half of said silicon surface.

12. Solar cell according to claim 11, wherein said silicon surface is covered with an antireflection coating.

## Patentansprüche

1. Verfahren zur Texturierung einer multikristallinen p-Typ Silizium-Oberfläche und ihrer Legierungen, umfassend einen Schritt der isotropen partiellen chemischen Oxidation der Oberfläche durch eine oxidierende Lösung, die ferner Fluor-Ionen umfasst, mit dem Ziel, an der Siliziumoberfläche eine poröse Oberflächenschicht zu schaffen,
**dadurch gekennzeichnet,**
**dass** der Schritt der Oxidation derart verwirklicht wird, dass die poröse Oberflächenschicht mit dem Kern des Materials eine Grenzschicht bildet, die eine mikro-texturierte Oberfläche aufweist, umfassend eine Mehrzahl von wabenförmigen Löchern, deren Tiefe und Durchmesser zwischen 0,1 µm und 10 µm enthalten ist, und deren Verhältnis der Tiefe zum Durchmesser größer als 1 ist, und
**dass** es ferner einen zweiten Schritt umfasst, der darin besteht, die poröse Oberflächenschicht aufzulösen, bis die mikro-texturierte Oberfläche freigegeben wird.

2. Verfahren nach Anspruch 1, bei dem die Lösung eine wässrige Säure ist.

3. Verfahren nach Anspruch 1, bei dem die Lösung eine organische Lösung ist.

4. Verfahren nach einem der Ansprüche 1 bis 3, bei dem die Lösung ein Oxidations-Agens umfasst, ausgewählt aus dem Chromat-Ion, dem Bromat-Ion, dem Nitrat-Ion, dem Nitrit-Ion, dem Amino-Ion, einem metallischen Redox-Paar, und ihren Mischungen.

5. Verfahren nach einem der Ansprüche 1 bis 4, bei dem die Lösung ferner ein Inhibitor-Agens enthält.

6. Verfahren nach einem der Ansprüche 1 bis 5, bei dem der zweite Schritt in einer Auflösung in einer Lösung besteht, ausgewählt aus einer wässrigen Alkalien-Lösung, einer organischen Ethylenglycol-Lösung und einer organischen Hydrazin-Lösung.

7. Verfahren nach Anspruch 6, bei dem die Auflösung ausgeführt wird in einer wässrigen Alkalien-Lösung, deren Alkalien-Konzentration zwischen 0,001 M und 2 M enthalten ist.

8. Verfahren nach einem der Ansprüche 6 und 7, bei dem das Alkalien ausgewählt wird aus Natriumhydroxid, Kaliumhydroxid, Ammoniak, und deren Mischungen.

9. Verfahren nach einem der Ansprüche 1 bis 8, umfassend ferner dem Schritt der chemischen Oxidation vorangehend einen Schritt des begrenzten chemischen Angriffs auf die Oberfläche durch eine wässrige Alkalien-Lösung bei einer Temperatur über 30°C.

10. Verfahren nach einem der Ansprüche 1 bis 9, umfassend ferner, nach dem zweiten Schritt, einen dritten Schritt, der in dem Ablegen einer Antireflex-Schicht auf der Oberfläche besteht.

11. Solarzelle, umfassend multikristallines p-Typ Silizium oder eines seiner Legierungen, mit einer Oberfläche zum Erfassen von Lichtstrahlung, wobei diese Oberfläche durch das Verfahren nach einem der Ansprüche 1 bis 9 texturiert ist, wobei die Oberfläche eine Mehrzahl von wabenförmigen Löchern aufweist, deren Tiefe zwischen 0,1 µm und 10 µm und deren Durchmesser zwischen 0,1 µm und 10 µm enthalten ist, wobei das Verhältnis der Tiefe zu dem Durchmesser größer als 1 ist, wobei die Oberfläche der Löcher mehr als die Hälfte der Oberfläche des Siliziums belegt.

12. Solarzelle nach Anspruch 11, bei der die Silizium-Oberfläche von einer Antireflex-Schicht überzogen ist.
